# EUROPEAN PATENT APPLICATION

(11) **EP 4 464 817 A2**
(43) Date of publication of application: **20.11.2024**
(21) Application number: 24175620.4
(22) Date of filing: 14.05.2024
(51) Int. Cl.: C23C 16/01, C23C 16/02, C23C 16/27, C30B 25/18, C30B 29/04

(54) **METHOD FOR SCALABLE FABRICATION OF ULTRAFLAT POLYCRYSTALLINE DIAMOND MEMBRANES**

(30) Priority: 15.05.2023 CN 202310540694
(71) Applicant: The University Of Hong Kong, Hong Kong Guangdon (HK); Dongguan Institute of Opto-Electronics Peking University, Dongguan Guangdong (CN); Southern University of Science and Technology, Shenzhen (CN)
(72) Inventor: CHU, Zhiqin, Hong Kong (HK); JING, Jixiang, Hong Kong (HK); WANG, Qi, Guangdong (CN); WANG, Zhongqiang, Guangdong (CN); LI, Kwai Hei, Shenzhen (CN)
(74) Representative: HGF

(57) **Abstract**

The present invention provides a method for scalable fabrication of ultra-flat polycrystalline diamond membranes, the method comprising: (1) performing chemical vapor deposition on a growth substrate having diamond seeds thereon to grow a polycrystalline diamond membrane, wherein an exposed surface of the polycrystalline diamond membrane is a grown surface having a first roughness; and a surface bonded to the growth substrate is a buried surface; (2) bonding the grown surface to a transfer substrate using an adhesive; and (3) removing the growth substrate to expose the buried surface of the polycrystalline diamond membrane, wherein the buried surface has a second roughness after exposure, and the second roughness is less than the first roughness.

## Description

### Cross-Reference to Related Patent Applications

This application claims the benefit of priority under 35 U.S.C. Section 119(a) of Chinese Patent Application No. 2023105406947 filed on 15 May 2023, which is incorporated herein by reference in its entirety.

### Technical field

The present invention relates to the fabrication of polycrystalline diamond membranes, and specifically. to a method for scalable fabrication of polycrystalline diamond membranes with an ultra-flat surface.

### Background Art

Diamond materials with outstanding intrinsic properties, such as extremely high thermal conductivity, broad optical transparency, wide bandgap, and ultrahigh mechanical hardness, are considered an ideal candidate for applications in the fields of mechanics, electronics, and optics. With the significant advances of high-pressure high temperature (HPHT) and chemical vapor deposition (CVD) techniques in recent years, large-scale lab-grown diamond materials, namely synthetic diamonds, have become available. In particular, the CVD process is capable of producing extremely pure diamonds for optical and mechanical applications. For example, diamond ultrathin membrane is a promising platform for developing various photonic structures, such as optical waveguides, resonators, meta-surfaces and meta-lenses.

Doped diamonds can further expand their use in electronic devices, such as boron-doped p-type semiconductors and superconductors, and quantum photonics based on atomic defects doped with nitrogen, silicon, etc. Particularly, those so-called next-generation diamond substrates, such as membranes, are expected to play an important role in the effective heat dissipation of electrical circuits and high-power electronic devices, especially for emerging soft/flexible electronics.

The realization of the above-mentioned diamond-based functional units will undoubtedly involve standard nanofabrication and seamless integration, all of which place increased demands on the surface roughness of diamond substances. Furthermore, a flat surface of the fabricated devices is also a prerequisite for many test/characterization methods widely used in related fields, such as thermal conductivity measurement and bonding in the semiconductor industry.

However, unlike other materials such as silicon, diamond materials are extremely difficult to flatten and using conventional methods, such as polishing, consumes significant time and energy.

Diamond membranes are mainly obtained by homogeneous and heterogeneous growth using chemical vapor deposition (CVD) techniques. Single crystal diamond (SCD) membranes are mainly obtained by homogeneous growth on bulk diamond substrates, which provides for the highest quality desired for many applications. For example, its high mobility for electrons and holes and its excellent resistance to radiation are also highly valuable for detectors in nuclear and high-energy physics experiments. However, the costly growth, limited scalability, and sophisticated processing of CVD-grown SCD have hindered its widespread use.

While heterogeneous growth of SCD on Iridium has been demonstrated in a quite limited number of laboratories worldwide, it is still difficult to control the quality of the diamond obtained, which tends to form polycrystalline diamond (PCD) membranes due to the lattice mismatch. Therefore, it remains highly challenging to establish large-area SCD membranes on arbitrary substrates.

In comparison, the scalable, cheap and much easier-to-grow polycrystalline diamond membranes are readily accessible on various common substrates, such as Si, SiC, TiC, Co, Pt, Al₂O₃, Ni and Re. In particular, continuous membranes can possibly be formed based on a sufficiently high density of nuclei, and the quality of the membrane is intimately related to the disorientation of the nuclei. To optimize the polycrystalline diamond membranes, researchers have proposed the concept of nanocrystalline and ultra-nanocrystalline diamond membranes by depositing the diamond seeds to form continuous nuclei. However, the unsatisfactory surface smoothness of the polycrystalline diamond membranes is one of the biggest bottlenecks in promoting such an excellent platform.

In summary, on the one hand, the extremely stringent growth conditions of single crystal diamond (SCD) severely hinder the use of diamond material in large-scale, cost-acceptable areas; on the other hand, polycrystalline diamond (PCD) is severely limited from further building high-precision photonic structures in the nano/micron scale due to poor surface morphology and high roughness caused by profile inhomogeneity.

### Summary of the Invention

It is therefore an object of the present invention to overcome the problems of poor surface morphologies and high roughness in the PCD and to present a simple approach to the fabrication of large-area, ultra-flat, and transferable polycrystalline diamond membranes in a scalable and controllable manner.

In a first aspect, the present invention provides a method for scalable fabrication of ultra-flat polycrystalline diamond membranes, comprising the steps of:
(1) performing chemical vapor deposition on a growth substrate having diamond seeds thereon to grow a polycrystalline diamond membrane, wherein a surface of the polycrystalline diamond membrane exposed to the air is a grown surface having a first roughness; and a surface at which the polycrystalline diamond membrane is bonded to the growth substrate is a buried surface;
(2) bonding the grown surface of the polycrystalline diamond membrane to a transfer substrate using an adhesive; and
(3) removing the growth substrate using one or more of grinding, dry etching and wet etching to expose the buried surface of the polycrystalline diamond membrane, wherein the buried surface has a second roughness after exposure, and the second roughness is less than the first roughness.

In the method according to the present invention, the first roughness may be 10 to 200 nm. In preferred embodiments of the present invention, the second roughness may be 1 to 10 nm, preferably 1 to 5 nm.

According to the method of the present invention, the buried surface has a higher refractive index than the grown surface. Preferably, the buried surface also has a lower extinction coefficient than the grown surface.

It was found that the levels of the optical parameters of the polycrystalline diamond membranes fabricated by the method of the present invention are comparable to that of SCD grown by the CVD method.

According to the method of the present invention, the position of the XRD diffraction peak for the (111) crystal face of the buried surface is closer to the position of the standard (111) crystal face XRD diffraction peak for single crystal diamond than the position of the XRD diffraction peak for the (111) crystal face of the grown surface. Further, the full width at half maximum (FWHM) of the Raman spectrum of the (111) crystal face for the buried surface is smaller than the full width at half maximum (FWHM) of the (111) crystal face for the grown surface. The shift of the XRD diffraction peak indicates the improvement of the crystalline quality, and the narrowing of the FWHM of the Raman spectrum indicates the improvement of the internal crystalline structure of the membrane.

In some embodiments of the present invention, the polycrystalline diamond membrane may have a thickness of 200 nm to 800 µm, preferably 200 nm to 1 µm.

According to the method of the present invention, the growth substrate and the transfer substrate can be the same or different, preferably different. In some embodiments of the present invention, the growth substrate may be selected from one or more of Si, SiC, TiC, Co, Pt, Al2O3, Ni, Re, Ir, SiO₂ and Mo. In some embodiments of the present invention, the growth substrate has a surface roughness of less than 2 nm, preferably less than 1 nm, more preferably less than 0.5 nm.

The transfer substrate may be any material and the present invention is not particularly limited with respect to the material of the transfer substrate. In order to provide temporary physical support for the polycrystalline diamond membrane during etching of the growth substrate, it is preferable for the transfer substrate to be a rigid material, such as one or more of ITO glass, common glass, silicon wafer, sapphire and gallium nitride.

According to the method of the present invention, the diamond seeds in step (1) have a particle size of 2 to 10 nm. Preferably, a microwave plasma-assisted chemical vapor deposition (MPCVD) device is used for the growth of the polycrystalline diamond membrane in step (1).

According to the method of the present invention, in step (2), various adhesives can be used to bond the grown surface of the polycrystalline diamond membrane to a transfer substrate, such as one or more of a poly(methyl methacrylate) (PMMA) electronic resist, a water-soluble poly(vinyl alcohol) or an acetone-soluble photoresist.

According to the method of the present invention, the dry etching in step (3) may be by means of inductively coupled plasma (ICP) etching and/or reactive ion etching; and the wet etching comprises using a solution to dissolve the growth substrate.

In preferred embodiments of the present invention, in order to increase the production efficiency and to avoid the rapid release of internal stresses that may lead to curling of the diamond membrane, step (3) can comprise removing the growth substrate using grinding, dry etching and wet etching sequentially.

According to an embodiment of the present invention, the method may further comprise the step of dissolving the electronic resist using a solvent to release the polycrystalline diamond membrane.

The present invention presents for the first time a novel and facile approach to develop large-area, ultra-flat, and transferable PCD diamond membranes in a scalable and controllable manner. The polycrystalline diamond membranes are successfully transferred from the growth substrate to arbitrary substrates by grinding, dry etching, and wet etching processes. The surface morphology and material properties of the buried surface have been carefully characterized to verify the effectiveness of the approach of the present invention. Moreover, the nano-/micro-scale patterning via bottom-up and top-down approaches is carried out to verify the feasibility of the developed membrane as a nano-/micro-processing platform.

### Brief Description of the Drawings

Hereinafter, embodiments of the present invention are described in detail in conjunction with the accompanying drawings, wherein:
FIG. 1 is a photograph of a polycrystalline diamond membrane fabricated in Example 1 of the present invention placed on a polydimethylsiloxane (PDMS) membrane (left panel) and an ITO glass (right panel), respectively.
FIG. 2A is a photograph of the as-grown polycrystalline diamond membrane (grown surface) on the silicon wafer in Example 1, and FIG. 2B is the corresponding SEM image, FIG. 2C is an AFM image thereof and FIG. 2D is a height variation graph of the dotted line marked in FIG. 2C.
FIG. 3A is a physical photograph of the transferred polycrystalline diamond membrane (buried surface) on ITO glass, FIG. 3B is the corresponding SEM image, FIG. 3C is an AFM image thereof and FIG. 3D is a height variation graph of the dotted line marked in (c).
FIG. 4A is the AFM image of a polished SCD sample and FIG. 4B is a graph of the magnitude variation of the measured cross section.
FIG. 5A shows a comparison of the refractive index of the grown surface of the as-grown polycrystalline diamond membrane on the silicon wafer in Example 1 to the extinction coefficient k, and FIG. 5B shows a comparison of the refractive index of the buried surface of the transferred polycrystalline diamond membrane on ITO glass to the extinction coefficient k.
FIG. 6 shows the XRD results for the grown surface of the as-grown polycrystalline diamond membrane on the silicon wafer in Example 1 and the buried surface of the transferred polycrystalline diamond membrane on ITO glass.
FIG. 7 shows the Raman spectra for the grown surface of the as-grown polycrystalline diamond membrane on the silicon wafer in Example 1 and the buried surface of the transferred polycrystalline diamond membrane on ITO glass.
FIGS. 8A-8D show the SEM images of the grating structures formed on the patterned grown surface and buried surface of the polycrystalline diamond membrane obtained in Example 2.
FIGS. 9A-9D show the SEM images of diamond pillar structures formed on the patterned grown surface and the buried surface of the polycrystalline diamond membrane obtained in Example 3.
FIGS. 10A-10F show the SEM images of the grown surfaces of the 400 nm thick and 1 µm thick polycrystalline diamond membranes fabricated in Example 4.

### Detailed Description of the Invention

The present invention is further described in detail below in connection with specific embodiments, wherein the given embodiments are for illustrative purposes only, and do not limit the scope of the invention.

### Example 1

### Fabrication of polycrystalline diamond membranes

### (1) Heteroepitaxial growth of diamond membranes

Heteroepitaxial growth of diamond on silicon substrate involves three steps: substrate pretreatment, diamond seed deposition and CVD growth of the diamond membrane.

Substrate pretreatment: The silicon surface is pretreated with hydrogen plasma, and a 2-inch silicon wafer is placed in the microwave plasma-assisted chemical vapor deposition (MPCVD) device for 10 minutes under conditions of 1300 W power, 35 Torr cavity pressure, and 300 sccm H₂ gas flow.

Diamond seed deposition: The diamond seeds (purchased from Tokyo Chemical Industry Company Limited) with a size of less than 10 nm are mixed with dimethyl sulfoxide (DMSO), anhydrous ethanol, and acetone in a mass ratio of 1:5000:250:250. The mixture is sonicated for 12 hours to disperse, and then centrifuged at a rotating speed of 1000 rpm for 20 minutes to separate impurities. The suspension is spin-coated onto the silicon wafer (depositing parameters: 500 rpm, 3 drops are added within 15 s, and then the rotating speed is increased to 4500 rpm for 110 s) and repeated three times.

CVD growth of the diamond membrane: The silicon wafer deposited with diamond seeds is placed in the MPCVD setup (Seki 6350) to grow a diamond membrane. The main growth parameters include 3400-W microwave power, 900 °C temperature, 15-sccm methane flow rate and 40 min growth time. As a result, about 450 nm thick polycrystalline diamond membranes are grown on the silicon substrate.

### (2) Substrate transfer of diamond membranes

The diamond membrane-on-silicon wafer is cut into small pieces, followed by cleaning in acetone, isopropyl alcohol, and deionized water for 10 min, and then drying with nitrogen gas. Another rigid substrate is used to support the diamond membrane after it is flipped off the silicon substrate. A 2 cm × 2 cm indium tin oxide (ITO) glass was selected in this example. A 10 µl drop of polymethyl methacrylate (PMMA) e-beam resist is applied to the surface of the ITO glass, which is used to bond the diamond membrane to the ITO substrate. The sample is placed in a vacuum chamber to degas the PMMA for 1 hour and the pressure of the vacuum chamber is maintained at -1 kg/cm². After a degassing process, the sample is heated at 100°C for 30 minutes to solidify the PMMA.

The bonded sample is subjected to grinding, dry and wet etching successively to remove the silicon substrate. Specifically, a crystal phase grinder with a 2000 C sandpaper mask is used to thin down the silicon substrate. The rotational speed of the grinder is initially set at 600 rpm, and then is reduced to 100 rpm when the thickness of the silicon substrate is below 100 µm. The purpose of reducing the rotational speed is to prevent the occurrence of crimping between the diamond membrane and the PMMA layer, which contributes to the rapid release of internal stress. When the thickness of the silicon substrate is reduced to about 20 µm, the sample is transferred to the ICP etcher for further precision etching. The etching gas is SF₆ at a flow rate of 92 sccm and O₂ was used as the shielding gas at a flow rate of 38 sccm. The RF voltage is set at 600 W and the bias voltage is set at 150 W, and the chamber pressure is fixed at 35 mTorr. The etching time is 15 minutes and the etching rate of silicon is about 1.3 µm/min. After ICP-etching of most of the silicon, the sample is immersed in 20% NaOH for 1 hour to remove residual silicon and is then rinsed with deionized water.

(3) The etched sample is immersed in acetone solvent to dissolve the PMMA layer. The arbitrary substrates are used to support the floating polycrystalline diamond membrane, followed by drying with nitrogen gas. In this example, the fabricated polycrystalline diamond membranes are placed on a polydimethylsiloxane (PDMS) membrane or an ITO glass for characterization.

### Example 2

### Patterning by Electron Beam Lithography (EBL)

The grown surface and the buried surface of the polycrystalline diamond membrane fabricated in Example 1 are each patterned using electron beam lithography equipment.

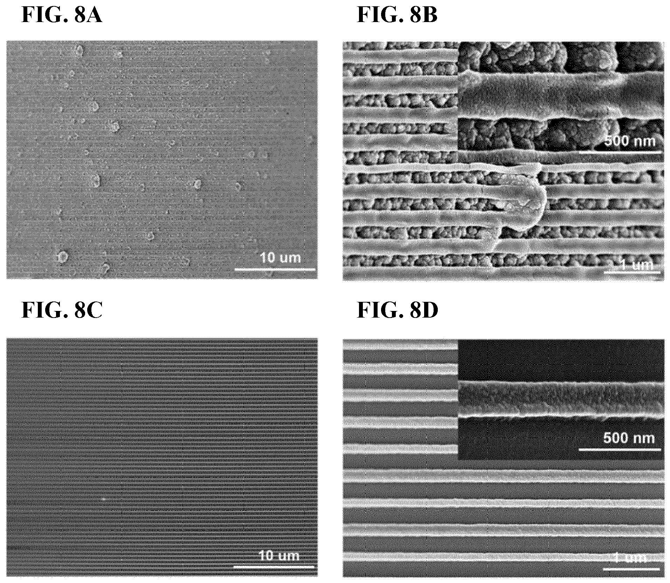

The PMMA 950 resist (3%) is spin-coated on the grown and buried surfaces at a rotation speed of 3000 rpm, and the thickness of the PMMA coating is about 150 nm. The coated PMMA resist is exposed to e-beam irradiation in an array of grating structures at a dose of 300 µC/cm² by EBL, and is then developed in a mixed solution of isopropyl alcohol (IPA) and water (1:3) at 0 °C. See the grating structures in FIGS. 8A-D.

### Example 3

### Preparation of diamond pillars

The pillar is one typical modality of nanostructures, the arrays of which in certain arrangement can be used as planar optical devices (such as metasurfaces, metalens, optical resonators). Therefore, the morphology of a single pillar will affect the performance of fabricated devices. The fabrication process determines the morphology of the fabricated pillar, which is related to the roughness of diamond membrane. A smoother surface will induce a well-defined nano-pillar and a well-controlled nano-pillar indicates that the buried surface of the diamond membrane of the present invention is capable of high-precision micro/nano fabrication.

Preparation of silica spheres as etching masks: The commercially available 200 nm silica spheres are suspended in 2.5% ethanol solvent. 20 µl of silica sphere suspension and 400 µl of ethanol solvent are pipetted together in a 1:20 ratio. The diluted mixture is ultrasonicated for 10 minutes to ensure dispersion of the silica spheres. After the dilution and dispersion of the silica spheres, a 10 µl droplet is taken with a pipette and placed on the grown and buried surfaces of the diamond membrane fabricated in Example 1. After evaporation of the solvent, a monolayer of silica spheres is formed on the grown and buried surfaces.

Dry etching of the diamond membrane: Oxygen gas at a flow rate of 30 sccm is used to etch the diamond material. The ICP RF voltage, bias voltage, and cavity pressure are set to 420 W, 60 W, and 10 mTorr, respectively. The etch time is 4 minutes and the etch rate is 1.7 nm/s.

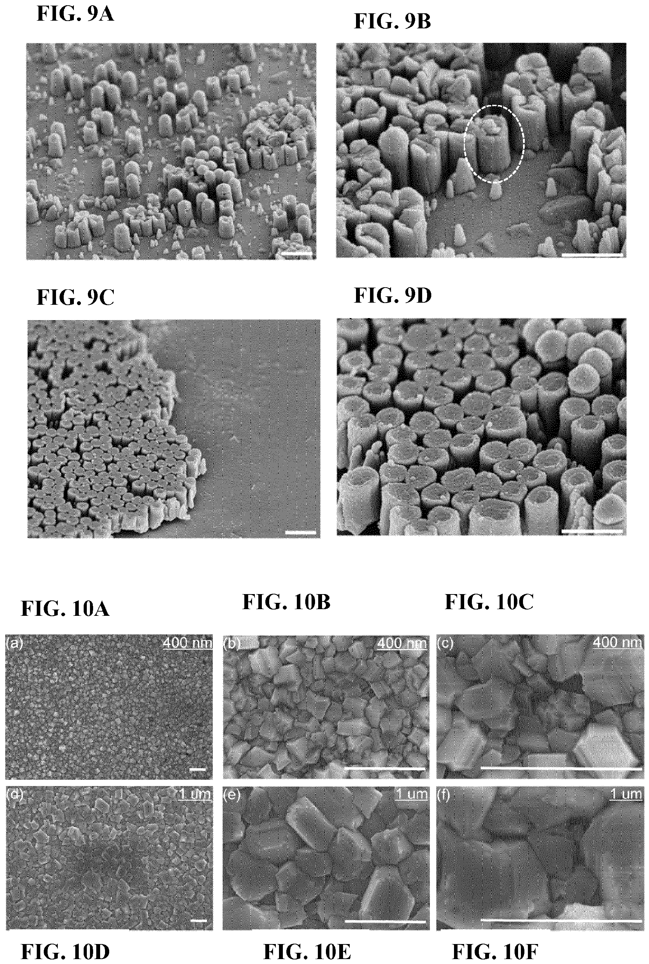

After etching, the silica spheres are removed by ultrasound leaving the diamond pillars as shown in FIGS. 9A-D.

### Characterization of surface morphology

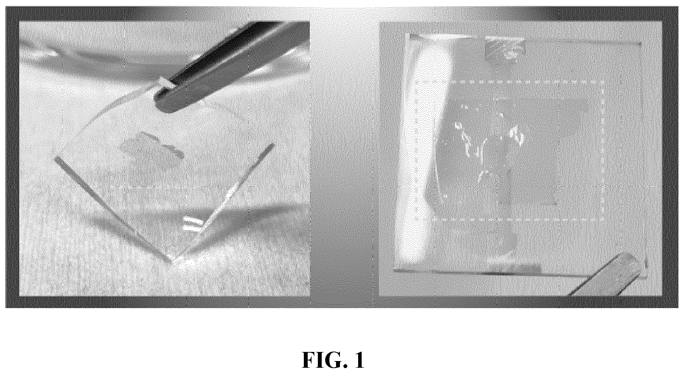

1. **FIG. 1** is a photograph of a polycrystalline diamond membrane fabricated according to Example 1 of the present invention placed on a polydimethylsiloxane (PDMS) membrane (left panel) and an ITO glass (right panel), respectively.

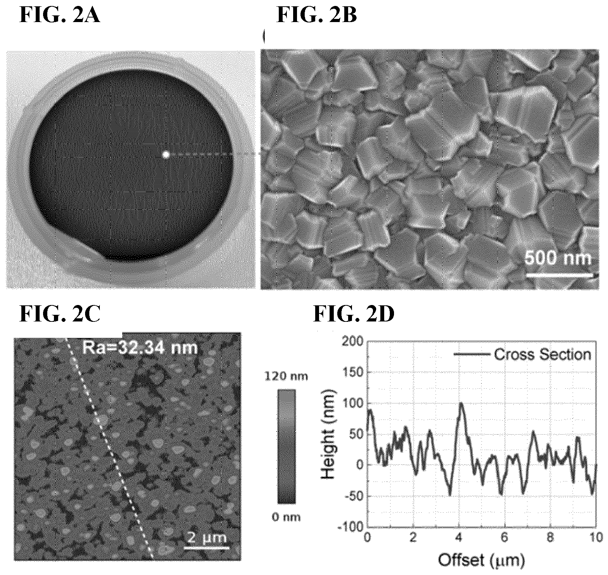

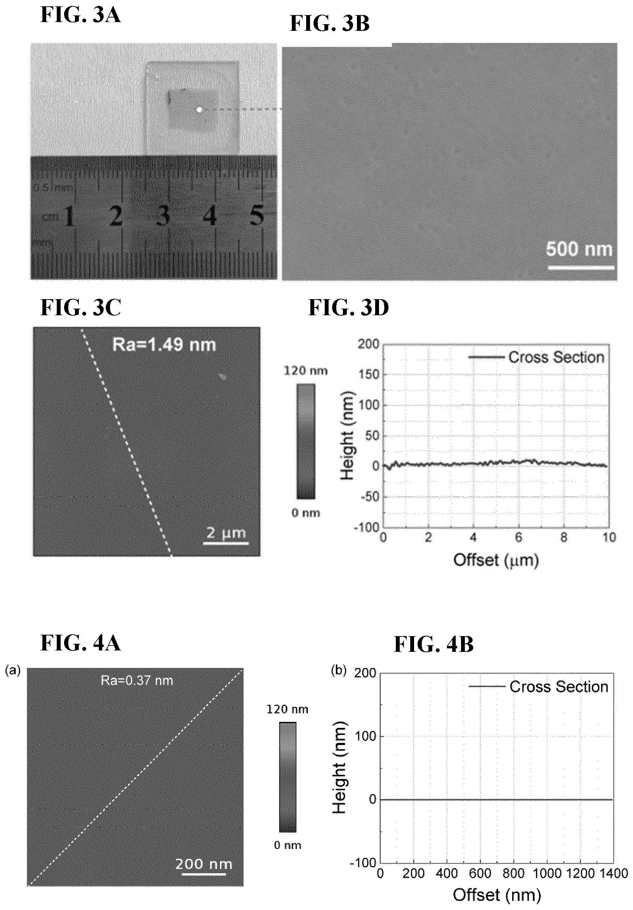

2. **FIG. 2A** is a physical photograph of the as-grown polycrystalline diamond membrane (grown surface) on the silicon wafer according to Example 1, and **FIG. 2B** is the corresponding SEM image, **FIG. 2C** is an AFM image of the sample and **FIG. 2D** is a height variation graph along the dotted line marked in FIG. 2C. **FIG. 3A** is a photograph of the transferred polycrystalline diamond membrane (buried surface) on an ITO glass, and **FIG. 3B** is the corresponding SEM image, while **FIG. 3C** is an AFM image thereof. **FIG. 3D** is the height variation graph of the dotted line marked in FIG. 3C.

A 450 nm thick diamond membrane grown on a silicon wafer (FIG. 2A) and transferred to an ITO glass (FIG. 3A) are characterized by scanning electron microscope (SEM), as shown in FIGS. 2B and 3B. According to the SEM images, there were some obvious grains on the grown surface, with a size mainly between 100-300 nm. In contrast, a smooth surface profile was obtained from the buried surface, but there were some negligible tiny holes caused by the corrosion of NaOH on silicon residuals. In order to quantify the smoothness of the diamond membrane, a 10 µm × 10 µm area was scanned using an atomic force microscope (AFM) to determine the average roughness. The results in FIGS. 2C and 3C show a pronounced decrease in roughness from 32.34 nm to 1.49 nm, approaching the level of a polished SCD surface. As shown in FIGS. 2D and 3D, the corresponding height variations of the cross sections marked in FIGS. 2C and 3C further confirm the significant improvement in the surface morphology of the buried surface compared to the grown surface.

3. In order to compare the difference between the buried surface of the flipped diamond membrane with standard polished single crystal diamond (SCD), the roughness for an SCD sample was characterized. The standard sample is commercially available from the company (Element Six). The result of the AFM measurement (**FIG. 4A**) shows that the surface roughness of SCD is about 0.37 nm. The magnitude variation of the defined cross section is shown in **FIG. 4B****.** As can be seen, although the roughness of the buried surface of the flipped polycrystalline diamond membranes is still larger than that of the SCD sample, the obvious decrease in roughness from 32.34 nm (grown surface) to 1.49 nm (buried surface) has successfully provided the condition for precise fabrication on the membrane.

### Characterization of the optical and material properties of the polycrystalline diamond membranes

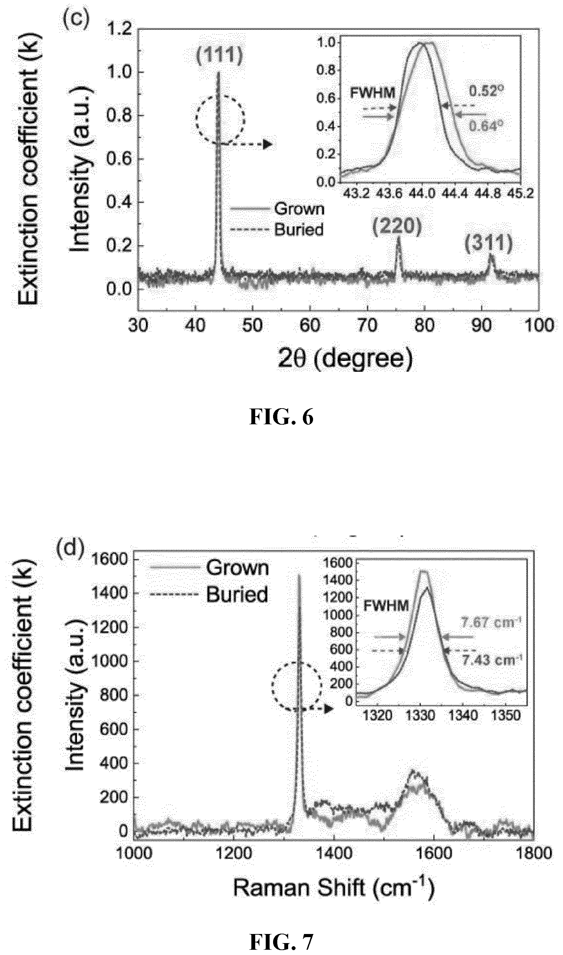

1. The refractive indices of the as-grown polycrystalline diamond membrane (grown surface) on the silicon wafer in Example 1 and the transferred polycrystalline diamond membrane (buried surface) on an ITO glass were measured using an optical ellipsometer.

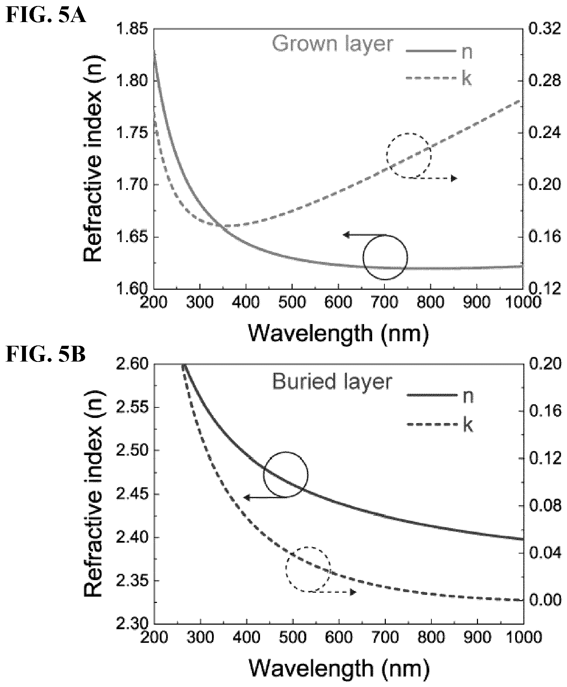

   **FIG. 5A** shows the comparison of the refractive index of the grown surface of the as-grown polycrystalline diamond membrane on the silicon wafer in Example 1 and **FIG. 5B** shows the buried surface of the transferred polycrystalline diamond membrane on an ITO glass, where n represents the refractive index and k represents the extinction coefficient. From the measured results in FIGS. 5A and B, the buried surface has a higher refractive index and lower extinction coefficient than the grown surface, and the levels of these optical parameters of the buried surface are found to be comparable to that of the SCD grown by the CVD method.
2. The crystalline nature of the polycrystalline diamond membranes fabricated in Example 1 is characterized using the x-ray diffraction (XRD) technique. As illustrated in **FIG. 6****,** the distinct diffraction peaks at 43.96°, 75.14° and 91.52° are obtained, corresponding to (111), (220) and (311) crystal faces, respectively, confirming the diamond nature of the buried surface. The strong diffraction peak of the (111) crystal face indicates its dominance, which is consistent with other reported works. Additionally, the full width at half maximum (FWHM) of the diffraction peak of the (111) crystal face for the buried surface is 0.64° narrower than that of the grown surface. In addition to the variation in the FWHM, the position of the diffraction peaks for the (111) crystal face exhibits a noticeable shift (FIG. 6, inset) from 44.36° (grown surface) to 43.96° (buried surface), which is close to the position (43.95°) of the standard (111)-oriented SCD. The shift in the diffraction peak indicates an improvement in the crystalline quality, which may be related to the release of internal stresses. Normally, due to the crystal lattice mismatch between the diamond and the heterogeneous substrate, residual stresses are introduced into the membranes, which further induce lattice distortion and result in an abnormal shift of the diffraction peak. By employing the fabrication method of the present invention, the residual stresses can be released after the removal of the growth substrate.
3. The crystalline nature of the polycrystalline diamond membrane fabricated in Example 1 is further characterized using Raman spectrum. From the Raman spectrum plotted in **FIG. 7****,** a distinct scattering peak of the diamond is observed at 1332.8 cm⁻¹, which further demonstrates the status of this membrane. Moreover, from the inset of FIG. 7, the FWHM of the buried surface (7.43 cm⁻¹) is narrower than that of the grown surface (7.67 cm⁻¹), implying the improvement of the internal crystalline structure of the membrane measured from the buried surface.

The improved optical performance and crystalline quality of the diamond membranes indicate their potential for the development of photonic structures.

### Characterization of nano-/micro-patterns on the polycrystalline diamond membranes

1. The grating structures formed on the patterned grown surface and buried surface of the polycrystalline diamond membrane obtained in Example 2 are characterized by SEM. The results are as shown in **FIG. 8A and FIG. 8B****,** which show the SEM images of the grown surface, and **FIG. 8C and FIG. 8D****,** which show the SEM images of the buried surface. A large number of particles for the grown surface can be seen in FIG. 8A, which are mainly formed during the spin-coating process of the PMMA resist. When the PMMA resist encounters the large grains distributed on the grown surface, these grains tend to aggregate, which degrades the uniformity of the coated resist. In contrast, the flat and smooth surface of the buried surface facilitates the uniform coating of the PMMA resist (FIG. 8C) and enables the formation of even grating patterns. From FIG. 8B, in the high-magnification SEM image, the grating structures obtained on the grown surface have obvious irregularities along the line patterns. As an optimization of the surface morphology, the grating structures fabricated on the buried surface (FIG. 8B) show a better performance in terms of uniformity over the grown surface.
2. The diamond pillar structures formed on the patterned grown surface and buried surface of the polycrystalline diamond membrane obtained in Example 3 are characterized by SEM. The results are as shown in FIGS. 9A-D, where **FIG. 9A** and **FIG. 9B** are the SEM images of the grown surface, and **FIG. 9C** and **FIG. 9D** are the SEM images of the buried surface, and the scale bars in the figures are all 500 nm. One pillar is indicated in a dotted-line oval in FIG. 9B.

As the large-scale grains on the grown surface behave in different orientations, the difference in the crystal faces leads to non-uniform etch rates. In addition, since the grain size of the grown surface is comparable to the diameter of the diamond pillars, the inhomogeneous morphology of diamond pillars is inevitable (FIG. 9B). Additionally, the grains on the top surface of the diamond pillars introduce irregular boundaries, which interact with adjacent ones intensively. On the other hand, utilizing the buried surface as an etching template results in well-defined diamond pillars without surface residues (FIG. 9C). The smooth and flat buried surface is favorable for obtaining flat tops and clear boundaries of individual pillars (FIG. 9D). The negligible residuals, flat top profile, and smooth boundaries of the fabricated diamond pillars based on the buried surface suggest the potential of the buried surface as an excellent platform for the fabrication of diamond-based photonic structures.

### Example 4

### Fabrication of polycrystalline diamond membranes with different thicknesses

According to the method of Example 1, polycrystalline diamond membranes with thicknesses of 400 nm and 1 µm are fabricated, respectively, and their surface morphology characteristics are characterized.

FIGS. 10A-F show the SEM images of the grown surfaces of the 400-nm-thick and 1-µm-thick polycrystalline diamond membranes, where **FIGS. 10A-10C** are different-magnification SEM images for a 400 nm thick diamond membrane and **FIGS. 10D-10F** are different-magnification SEM images for a 1-µm-thick diamond membrane. The scale bars are all 500 nm.

The characterized surface morphology for the grown surface of the polycrystalline diamond membranes with different thicknesses are shown in FIGS. 10A-F. The grain size increases significantly as the membrane thickness increases from 400 nm in FIGS. 10A-C to 1 µm in FIGS. 10D-F, resulting in a rougher surface for the membrane. Therefore, the difference in roughness between the grown surface and the buried surface continues to increase. It will also be more difficult to fabricate structures on the thicker diamond membranes. The strategy of flipping the diamond membrane provided by the present invention is vital for acquiring ultra-flat diamond membranes, especially for the thicker ones.

As can be seen from the above examples, the fabrication method of the present invention acquires large-area, ultra-flat diamond membranes by transferring the polycrystalline diamond membrane from the growth substrate to an arbitrary substrate. The buried diamond layer has a smooth surface with an average roughness of 1.49 nm compared to 32.34 nm for the grown surface. The XRD and Raman measurements indicate that the buried surface exhibits a significant improvement in the crystalline properties over the as-grown surface, which is attributable to the relaxation of internal stress in the diamond membrane. Additionally, bottom-up and top-down micro/nano patterning on the membrane is performed in Examples 2 and 3 and the observation of high-precision well-defined structure obtained on the buried surface confirms the feasibility of the membrane platform. The method of the present invention opens up new prospects for the practical development of polycrystalline diamond membranes, which lays an important foundation for accelerating the research and application of diamond materials in various fields.

## Claims

1. A method for scalable fabrication of ultra-flat polycrystalline diamond membranes, comprising:
(1) performing chemical vapor deposition on a growth substrate having diamond seeds thereon to grow a polycrystalline diamond membrane, wherein a surface of the polycrystalline diamond membrane exposed to the air is a grown surface having a first roughness and a surface at which the polycrystalline diamond membrane is bond to the growth substrate is a buried surface;
(2) bonding the grown surface of the polycrystalline diamond membrane to a transfer substrate using an adhesive; and
(3) removing the growth substrate to expose the buried surface of the polycrystalline diamond membrane, wherein the buried surface has a second roughness after exposure, and the second roughness is less than the first roughness.

2. The method according to claim 1 wherein the step of removing the growth substrate is achieved by one or more of grinding, dry etching and wet etching.

3. The method according to claim 1 or 2, wherein the first roughness is 10 to 200 nm; and the second roughness is 1 to 10 nm, more preferably 1 to 5 nm.

4. The method according to any of claims 1-3, wherein the buried surface has a higher refractive index than the grown surface; and the buried surface has a lower extinction coefficient than the grown surface.

5. The method according to any of claims 1-4, wherein the position of an XRD diffraction peak for the (111) crystal face of the buried surface is closer to the position of the standard (111) crystal face XRD diffraction peak for single crystal diamond than the position of the XRD diffraction peak for the (111) crystal face of the grown surface; and the full width at half maximum of the XRD diffraction peak of the (111) crystal face for the buried surface is less than the full width at half maximum of the XRD diffraction peak of the (111) crystal face for the grown surface.

6. The method according to any of claims 1-5, wherein the polycrystalline diamond membrane has a thickness of 200 nm to 800 µm, preferably 200 nm to 1 µm.

7. The method according any of claims 1-6, wherein the growth substrate is selected from one or more of Si, SiC, TiC, Co, Pt, Al₂O₃, Ni, Re, Ir, SiO₂ and Mo.

8. The method according to any of claims 1-7, wherein the growth substrate has a surface roughness of less than 2 nm, preferably less than 1 nm, more preferably less than 0.5 nm.

9. The method according to any of claims 1-8, wherein the adhesive is a resist, such as one or more of a poly(methyl methacrylate) electronic resist, a water-soluble poly(vinyl alcohol), an acetone-soluble photoresist.

10. The method according to any of claims 1-9, wherein the diamond seeds in step (1) have a particle size of 2 to 10 nm; and
a microwave plasma-assisted chemical vapor deposition device is used for the growth of the polycrystalline diamond membrane in step (1).

11. The method according to claim 2, wherein the dry etching in step (3) is achieved with inductively coupled plasma (ICP) etching and/or reactive ion etching; and the wet etching comprises using a solution to dissolve the growth substrate;
preferably, step (3) comprises removing the growth substrate using grinding, dry etching and wet etching sequentially.
